# EUROPÄISCHE PATENTSCHRIFT

(11) **EP 4 150 383 B1**
(45) Veröffentlichungstag und Bekanntmachung des Hinweises auf die Patenterteilung: **02.12.2026**
(21) Anmeldenummer: 21726581.8
(22) Anmeldetag: 10.05.2021
(51) Int. Cl.: G02B 5/08, G02B 5/10, G02B 5/18, G03F 7/00, G03F 7/20

(54) **VERFAHREN ZUM HERSTELLEN EINES OPTISCHEN ELEMENTS**
METHOD FOR PRODUCING AN OPTICAL ELEMENT
PROCÉDÉ DE PRODUCTION D'UN ÉLÉMENT OPTIQUE

(30) Priorität: 14.05.2020 DE 102020206107
(43) Veröffentlichungstag der Anmeldung: 22.03.2023
(73) Patentinhaber: Carl Zeiss SMT GmbH, 73447 Oberkochen (DE)
(72) Erfinder: WINTER, Ralf, 73539 Schwäbisch Gmünd (DE); SHKLOVER, Vitaly, 89522 Heidenheim (DE)
(74) Vertreter: Rau, Schneck & Hübner Patentanwälte Rechtsanwälte PartGmbB
(86) Internationale Anmeldenummer: PCT/EP2021/062304
(87) Internationale Veröffentlichungsnummer: WO 2021/228756

(56) Entgegenhaltungen:
- DE-A1- 10 258 094
- DE-A1- 102016 205 893
- DE-A1- 102019 200 698
- ZHOU HAN ET AL: "Molecular Layer Deposition of Functional Thin Films for Advanced Lithographic Patterning", APPLIED MATERIALS & INTERFACES, vol. 3, no. 2, 23 February 2011 (2011-02-23), US, pages 505 - 511, XP055827209, ISSN: 1944-8244, Retrieved from the Internet <URL:https://pubs.acs.org/doi/pdf/10.1021/am1010805> [retrieved on 20210723], DOI: 10.1021/am1010805

## Beschreibung

Die Erfindung betrifft ein Verfahren zum Herstellen eines optischen Elements mit einer optischen Fläche, die eine Beugungsstruktur aufweist. Ferner betrifft die Erfindung ein optisches Element, hergestellt mit einem derartigen Verfahren, ein Beleuchtungssystem mit einem derartigen optischen Element, eine Projektionsbelichtungsanlage mit einem derartigen Beleuchtungssystem, sowie ein Verfahren zur Herstellung eines mikro- oder nanostrukturierten Bauelements mithilfe einer derartigen Projektionsbelichtungsanlage.

Ein Beispiel für ein optisches Element mit einer optischen Fläche, die derart gekrümmt ist, dass ein Abstands-Durchmesser-Verhältnis zwischen einem Abstand, gemessen längs einer gemittelten Flächennormalen zwischen einem tiefsten und einem höchsten Punkt auf der optischen Fläche und einem größten Durchmesser größer als 1/10, ist ein Kollektor für EUV-Strahlen als Bestandteil eines Beleuchtungssystems einer EUV-Projektionsbelichtungsanlage. Ein Beispiel für einen derartigen Kollektor ist dem Fachmann bekannt aus der US 9,541,685 B2. Eine Reflexionsfläche des dortigen Kollektors wird mithilfe eines Diamant-Drehverfahrens hergestellt.

DE 10 2019 200 698 A1 offenbart ein Verfahren zum Herstellen eines EUV-Kollektors mit einer gekrümmten optischen Fläche und einem Binärgitter zur Beugung von Falschlicht. Das Binärgitter wird mittels Fotolack hergestellt.

DE 10 2016 205 893 A1 offenbart einen EUV-Kollektor mit einer gekrümmten optischen Fläche und einem Beugungsgitter zur Unterdrückung von Falschlicht.

DE 102 58 094 A1 offenbart ein Verfahren zur elektrophoretischen Abscheidung von Photoresist.

ZHOU HAN ET AL: "Molecular Layer Deposition of Functional Thin Films for Advanced Lithographie Patterning", APPLIED MATERIALS & INTERFACES, Bd. 3, Nr. 2, 23. Februar 2011 (2011-02-23), Seiten 505-511, US, ISSN: 1944-8244, DOI: 10.1021/am1010805 offenbart ein Verfahren zur Molekularlagenabscheidung von Photoresist.

Aus der US 6,352,747 B1 ist ein Verfahren zur Beschichtung gekrümmter Oberflächen mittels Spraycoating bekannt. Ein derartiges Verfahren kann grundsätzlich zur Auftragung eines Photoresists zur Erzeugung von Beugungsstrukturen auf optischen Flächen herangezogen werden. Soweit Beugungsstrukturen mit hohen Anforderungen an eine Strukturgenauigkeit hergestellt werden müssen, stößt das Spraycoating-Verfahren jedoch an seine Grenzen.

Es sei weiterhin auf folgenden Stand der Technik verwiesen:
- Mitzutani, A. et al..: "Two-spherical-wave ultraviolet interferometer for making an anti-reflective subwavelength periodic pattern on a curved surface", APPLIED OPTICS Vol. 49, No. 32, Seiten 6268-6275 (2010);
- Eckstein, H.-C. et al.: "High dynamic grayscale lithography with an LED-based micro-image stepper", Proc. Of SPIE Vol. 9780, Seiten 97800T-1 bis 97800T-7 (2016);
- Li, Z. et al.: "Towards a portable Raman spectrometer using a concave grating and a time-gated CMOS SPAD", OPTICS EXPRESS Vol. 22, No. 15, Seiten 18736-18747 (2014);
- Xie, Y. et al.: "Fabrication of large diffractive optical elements in thick film on a concave lens surface", OPTICS EXPRESS Vol. 11, No. 9, Seiten 992-995 (2003);
- JP H08- 146 209 A;
- DE 10 2016 209 359 A1;
- DE 10 2017 221 746 A1;
- DE 10 2019 214 243 A1.

Es ist eine Aufgabe der vorliegenden Erfindung, ein Herstellungsverfahren für ein optisches Element mit einer eine Beugungsstruktur aufweisenden optischen Fläche derart weiterzubilden, dass das Verfahren hohen Anforderungen an eine Strukturgenauigkeit bei der Erzeugung der Beugungsstruktur gerecht wird.

Diese Aufgabe ist erfindungsgemäß gelöst durch ein Herstellungsverfahren mit den in Anspruch 1 angegebenen Merkmalen.

Ein Abstands-Durchmesser-Verhältnis A/D kann beim hergestellten optischen Element größer sein als 1/8, kann größer sein als 1/5, kann größer sein als 1/4, kann größer sein als 1/2 und kann auch größer sein als 1/1. Eine Obergrenze für das Abstands-Durchmesser-Verhältnis A/D kann 1/1 sein. Bei der gemittelten Flächennormalen handelt es sich um den Richtungs-Mittelwert, gemittelt über die Richtungen aller Normalen auf Flächenabschnitten der optischen Fläche. Bei einer rotationssymmetrischen optischen Fläche mit zur Rotationssymmetrieachse ebenfalls rotationssymmetrischer Berandungsfläche entspricht die Richtung der gemittelten Flächennormalen der Richtung der Rotationssymmetrieachse.

Bei der optischen Fläche des optischen Elements kann es sich um eine Reflexionsfläche handeln. Alternativ kann es sich bei der optischen Fläche auch um eine refraktive Fläche handeln. Ein Roh-Abstands-Durchmesser-Verhältnis der optischen Roh-Fläche kann vom Abstands-Durchmesser-Verhältnis A/D der herzustellenden optischen Fläche um nicht mehr als 10 % abweichen. Die optische Roh-Fläche kann hinsichtlich ihrer konvexen/konkaven Krümmung eine Grundkrümmung aufweisen, die derjenigen der optischen Fläche des herzustellenden Elements entspricht.

Vor dem Beschichten der optischen Roh-Fläche mit dem Photoresist kann ein Beschichten des Grundkörpers der optischen Roh-Fläche mit einer strukturierbaren Schicht erfolgen, in die dann die Beugungsstruktur eingebracht wird. Das Beschichten des Grundkörpers mit der strukturierbaren Schicht einerseits und das Entwickeln des Photoresists andererseits sind aus dem Stand der Technik bekannt. In Bezug auf diese Schritte, die sich nicht grundsätzlich vom Spraycoating als Photoresist-Beschichtungsschritt verwendenden Stand der Technik unterscheiden, wird verwiesen auf den Fachartikel "Spraycoating of photoresist for pattern transfer on high topography surfaces" von Pham et al., J. Micromech. Microeng. 15 (2005) 691 bis 697, und auf den Fachartikel "Spraycoating of photoresist for 3D microstructures with different geometries" von Yu et al. Journal of Physics: Conference Series 34 (2006) 937 bis 942.

Nach dem Entwickeln des Photoresists kann sich ein Entfernen von Photoresist-Rückständen anschließen. Das Beschichten mit dem Photoresist und das Entwickeln des Photoresists können während des Herstellungsverfahrens auch mehrfach hintereinander erfolgen. Nach dem Herstellen der Beugungsstruktur kann diese mit einer Versiegelungsschicht versiegelt werden, was aus dem Stand der Technik ebenfalls bekannt ist.

Das isotrope Abscheideverfahren gewährleistet eine konforme, homogene Beschichtung der optischen Roh-Fläche mit dem Photoresist. Bereits im optischen Roh-Element vorliegende Strukturen werden beim Beschichten dann nicht ausgeschmiert oder verwaschen, sondern bleiben auch im Photoresist erhalten. Die isotrope, homogene Beschichtung gewährleistet zudem, dass mit dem gerichteten Beschichtungsverfahren nach dem Stand der Technik schwer oder nicht zugängliche Bereiche ebenfalls mit dem Photoresist in gewünschter Weise beschichtet werden. Auch in einem vorausgehenden Schritt bereits erzeugte Strukturflanken der optischen Beugungsstruktur werden dann, soweit dies bei einem nachfolgenden Photoresist-Beschichtungsschritt erwünscht ist, isotrop mit gewünschter Schichtdicke mit dem Photoresist beschichtet. Dies ist auch bei hohen Flankensteilheiten der bereits vorliegenden Strukturflanken möglich. Das isotrope Abscheideverfahren ist insbesondere gravitationsunabhängig.

Die Beugungsstrukturen eines optischen Elements, das mit dem Verfahren hergestellt wird, sind derart ausgeführt, dass beim Beaufschlagen des optischen Elements mit Beleuchtungslicht mindestens eine Falschlicht-Wellenlänge durch Beugung unterdrückt wird, die sich von einer Beleuchtungslicht-Wellenlänge des Beleuchtungslichts unterscheidet, für welches das optische Element ausgelegt ist. Eine derartige Ausführung der Beugungsstrukturen hat sich zur Falschlichtunterdrückung bewährt. Das gemäß dem Verfahren hergestellte optische Element hat zudem derart ausgeführte Beugungsstrukturen, dass beim Beaufschlagen des optischen Elements mit Beleuchtungslicht zwei sich voneinander unterscheidende Falschlicht-Wellenbereiche unterdrückt werden. Eine derartige Ausführung der Beugungsstrukturen ist besonders auf die Anforderungen an eine LPP-Quelle (Plasmaerzeugung durch Laser, laser produced plasma) angepasst, bei der dann einerseits ein Falschlicht-Wellenlängenbereich um eine Laser-Pumplicht-Wellenlänge und andererseits ein weiterer Falschlicht-Wellenlängenbereich um die Nutzlicht-Wellenlänge des Beleuchtungslichts unter Aussparung genau dieser Nutzlicht-Wellenlänge unterdrückt werden kann.

Beim hergestellten optischen Element ist die Beugungsstruktur derart ausgeführt, dass beim Beaufschlagen des optischen Elements mit Beleuchtungslicht mindestens eine Falschlicht-Wellenlänge durch Beugung unterdrückt wird, die sich von einer Beleuchtungslicht-Wellenlänge des Beleuchtungslichts unterscheidet, für welches das optische Element ausgelegt ist.

Zudem sind die Beugungsstrukturen des hergestellten optischen Elements derart ausgeführt, dass beim Beaufschlagen des optischen Elements mit Beleuchtungslicht zwei sich voneinander unterscheidende Falschlicht-Wellenlängenbereiche unterdrückt werden. Eine derartige Ausführung der Beugungsstrukturen hat sich zur Falschlichtunterdrückung bewährt.

Der eine der beiden zu unterdrückenden Falschlicht-Wellenlängenbereiche ist ein IR-Wellenlängenbereich, beispielsweise im Bereich zwischen 10 µm und 11 µm, der andere der beiden zu unterdrückenden Falschlicht-Wellenlängenbereiche ist ein VUV-Wellenlängenbereich zwischen 100 nm und 200 nm.

Bei dem optischen Element handelt es sich insbesondere um ein Multiband-Gitter, welches zur Beugung unterschiedlicher Wellenlängenbereiche, insbesondere einerseits im VUV und andererseits im IR, ausgelegt ist. Eine Auftrags-Schichtdicke nach Anspruch 2 hat sich in der Praxis bewährt. Eine absolute Auftrags-Schichtdicke des Photoresists kann im Bereich zwischen 5 µm und 15 µm, kann im Bereich zwischen 6 µm und 12 µm und kann im Bereich zwischen 8 µm und 10 µm liegen. Diese Schichtdicke kann insbesondere bei 8 µm, bei 9 µm und bei 10 µm liegen.

Eine Dickenvariation des mittels des isotropen Abscheideverfahrens aufgetragenen Photoresists nach Anspruch 3 ermöglicht ein sehr definiertes nachfolgendes Entwickeln des Photoresists unabhängig von Photoresist-Dickeneffekten. Die Dickenvariation, also der Unterschied zwischen einer maximalen und einer minimalen Photoresist-Dicke über einen vorgegebenen Abschnitt der vorgegebenen Fläche, insbesondere über die gesamte optische Fläche, auf der die Beugungsstrukturen aufgebracht werden sollen, kann kleiner sein als 15%, kann kleiner sein als 10% und kann auch kleiner sein als 5%. Die Dickenvariation ist regelmäßig größer als 1%. Eine absolute Dickenvariation des aufgetragenen Photoresists kann kleiner sein als 2 µm. Dies gilt insbesondere für absolute Photoresist-Dicken, die größer sind als 10 µm, Die Dickenvariation kann sogar deutlich kleiner sein als 2µm, kann kleiner sein als 1,5 µm, kann kleiner sein als 1,0 µm, kann kleiner sein als 0,7 µm, kann kleiner sein als 0,5 µm und kann beispielsweise 0,4 µm betragen.

Ein Photoresist-Beschichten mittels elektrophoretischer Abscheidung nach Anspruch 4 hat sich in der Praxis bewährt. Die elektrophoretische Abscheidung ist bekannt aus der US 3,738,835 und der DE 10 258 094 A1.

Auch die Moleküllagenabscheidung zur Photoresist-Beschichtung hat sich bei der Herstellung der Beugungsstrukturen des optischen Elements bewährt. Die Moleküllagenabscheidung ist bekannt aus der US 2012/0121932 A1.

Die Vorteile eines optischen Elements nach Anspruch 6 entsprechen denen, die vorstehend unter Bezugnahme auf das Herstellungsverfahren bereits erläutert wurden.

Bei der hergestellten optischen Beugungsstruktur kann es sich um eine multiperiodische Beugungsstruktur, um eine binäre Beugungsstruktur, um eine ternäre Beugungsstruktur sowie um eine Beugungsstruktur mit mehr als drei Stufen beziehungsweise Strukturniveaus handeln. Die Anzahl von Perioden einer mit dem Herstellungsverfahren hergestellten multiperiodischen Beugungsstruktur kann größer oder gleich 2 sein. Bei der hergestellten optischen Beugungsstruktur kann es sich alternativ oder zusätzlich um eine Fresnel-Linse, um ein zwei- oder mehrdimensionales Gitter sowie um ein computergeneriertes Hologramm (CGH) handeln.

Die Vorteile des Herstellungsverfahrens kommen bei einem EUV-Kollektor nach Anspruch 7 besonders gut zum Tragen. Die optische Beugungsstruktur wird dort zur Falschlicht-Unterdrückung genutzt. Es wird dadurch vermieden, dass unerwünscht mit dem EUV-Nutz-Beleuchtungslicht mitgeführtes Falschlicht nachfolgende optische Komponenten einer Projektionsbelichtungsanlage, die das Nutzlicht führen sollen, beaufschlagt.

Bei einem Durchmesser der optischen Fläche nach Anspruch 8 kommen die Vorteile des Herstellungsverfahrens besonders gut zum Tragen. Der Durchmesser kann größer sein als 150 mm, kann größer sein als 200 mm, kann größer sein als 250 mm, kann größer sein als 300 mm, kann größer sein als 500 mm, kann größer sein als 2 m und kann auch größer sein als 5 m. Eine Obergrenze für den Durchmesser kann bei 10 m liegen.

Eine Flankensteilheit nach Anspruch 9 hat sich zur Erzielung eines gewünschten Beugungsergebnisses als vorteilhaft herausgestellt. Die Flankensteilheit kann größer sein als 20°, kann größer sein als 30°, kann größer sein als 40°, kann größer sein als 50°, kann größer sein als 60°, kann größer sein als 70°, kann größer sein als 80° und kann auch größer sein als 90°, sodass Beugungsstrukturen entstehen können, deren Strukturprofile sich einem Strukturgrund hin verjüngen. Eine Obergrenze für die Flankensteilheit kann bei 110° oder auch bei 100° liegen. Eine bevorzugte Flankensteilheit liegt im Bereich von 90°. Kleinere Flankensteilheiten können insbesondere zur Herstellung geblazeter optischer Beugungsgitterstrukturen, also zur Herstellung von Blaze-Beugungsgittern, genutzt werden. Innerhalb des jeweiligen Falschlicht-Wellenlängenbereichs können mehrere diskrete Falschlicht-Wellenlängen unterdrückt werden, zum Beispiel sich unterscheidende Impuls- und Mainpuls-Wellenlänge bei einer LPP-Strahlungsquelle oder auch verschiedene durch das Plasma erzeugte EUV- und VUV-Falschlicht-Wellenlängen.

Die Vorteile eines Beleuchtungssystems nach Anspruch 11, einer Projektionsbelichtungsanlage nach Anspruch 12**,** eines Herstellungsverfahrens nach Anspruch 13 sowie eines nach dem Verfahren hergestellten Bauelements entsprechen denen, die vorstehend unter Bezugnahme auf das Herstellungsverfahren und auf das hergestellte optische Element bereits erläutert wurden. Bei dem hergestellten Bauelement kann es sich um ein Microchip handeln, insbesondere um einen Speicherchip.

Ausführungsbeispiele der Erfindung werden nachfolgend anhand der Zeichnung näher beschrieben. In dieser zeigen:
- Fig. 1: schematisch in einem Meridionalschnitt eine Projektionsbelichtungsanlage für die EUV-Projektionslithografie;
- Fig. 2: einen Meridionalschnitt durch einen Kollektor der Projektionsbelichtungsanlage;
- Fig. 3 bis 6: Momentaufnahmen in Form von Meridionalschnitten durch einen Abschnitt einer optischen (Roh-)Fläche des Kollektors bei dessen Herstellung;
- Fig. 7: in einer zu Fig. 6, die eine hergestellte 3-Niveau-Beugungsstruktur mit Strukturen mit 90°-Flankensteilheit zeigt, ähnlichen Darstellung eine 3-Niveau-Beugungsstruktur mit Flanken mit 45°-Flankensteilheit als weitere Ausführung eines hergestellten optischen Elements mit Beugungsstrukturen;
- Fig. 8: schematisch zwei Flankenabschnitte einer Beugungsstruktur zur Veranschaulichung einer Definition des Parameters "Flankensteilheit";
- Fig. 9: in einer zu den Fig. 6 und 7 ähnlichen Darstellung eine weitere Ausführung eines hergestellten optischen Elements mit Beugungsstrukturen in Form eines multiperiodischen Gitters; und
- Fig. 10: in einer zu den Fig. 6, 7 und 9 ähnlichen Darstellung eine weitere Ausführung eines hergestellten optischen Elements mit Beugungsstrukturen in Form eines mehrfachstufigen Git- ters mit einer Vielzahl von Niveaus und einer Mehrzahl von Niveauunterschieden.

Zunächst wird der generelle Aufbau einer Projektionsbelichtungsanlage 1 für die Mikro-Lithographie beschrieben.

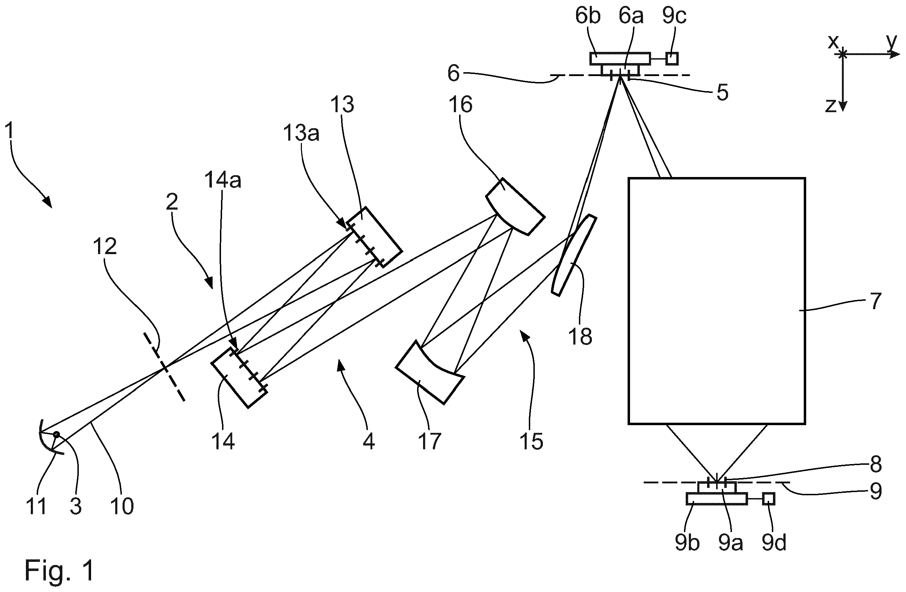

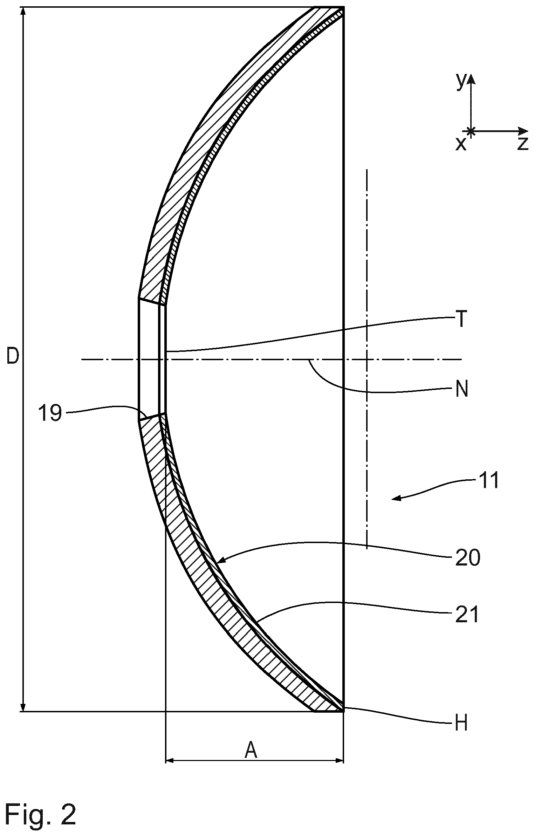

Zur Beschreibung wird ein kartesisches xyz-Koordinatensystem herangezogen. Die x-Achse verläuft in der Fig. 1 senkrecht zur Zeichenebene in diese hinein. Die y-Achse verläuft nach rechts. Die z-Achse verläuft nach unten. Im Zusammenhang mit der Beschreibung einzelner Komponenten wird in den Figuren 2 folgende ein lokales kartesisches xyz-Koordinatensystem verwendet, welches so angeordnet ist, dass die x-Achse des lokalen Koordinatensystems parallel zur x-Achse des globalen Koordinatensystems nach Fig. 1 verläuft und die x- und y-Achsen jeweils eine an eine jeweilige optische Fläche angenäherte Hauptebene aufspannen.

Fig. 1 zeigt schematisch in einem Meridionalschnitt eine Projektionsbelichtungsanlage 1 für die Mikro-Lithographie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Belichtet wird hierbei ein im Objektfeld 5 angeordnetes Retikel 6a, das von einem Retikelhalter 6b gehalten ist. Eine Projektionsoptik 7 dient zur Abbildung des Objektfeldes 5 in ein Bildfeld 8 in einer Bildebene 9. Abgebildet wird eine Struktur auf dem Retikel auf eine lichtempfindliche Schicht eines im Bereich des Bildfeldes 8 in der Bildebene 9 angeordneten Wafer 9a, der von einem Waferhalter 9b gehalten ist.

Der Retikelhalter 6b wird von einem Retikelverlagerungsantrieb 9c und der Waferhalter 9b wird von einem Waferverlagerungsantrieb 9d angetrieben.

Die Antriebe mittels der beiden Verlagerungsantriebe 9c, 9d erfolgen synchronisiert zueinander längs der y-Richtung.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, gas discharge-produced plasma) oder um eine LPP-Quelle (Plasmaerzeugung durch Laser, laserproduced plasma) handeln. Beispielsweise kann Zinn mittels einem bei einer Wellenlänge von 10,6 µm, das heißt im Infrarot-Bereich, arbeitenden Kohlendioxidlaser zu einem Plasma angeregt werden. Auch eine Strahlungsquelle, die auf einem Synchrotron basiert, ist für die Strahlungsquelle 3 einsetzbar. Informationen zu einer derartigen Strahlungsquelle findet der Fachmann beispielsweise in der US 6,859,515 B2. EUV-Strahlung 10, die von der Strahlungsquelle 3 ausgeht, wird von einem Kollektor 11 gebündelt. Ein entsprechender Kollektor ist vom Grundaufbau her aus der US 9,541,685 B2 bekannt. Nach dem Kollektor 11 propagiert die EUV-Strahlung 10 durch eine Zwischenfokusebene 12, bevor sie auf einen Feldfacettenspiegel 13 mit einer Vielzahl von Feldfacetten 13a trifft. Der Feldfacettenspiegel 13 ist in einer Ebene der Beleuchtungsoptik 4 angeordnet, die zur Objektebene 6 optisch konjugiert ist.

Die EUV-Strahlung 10 wird nachfolgend auch als Beleuchtungslicht oder als Abbildungslicht bezeichnet.

Nach dem Feldfacettenspiegel 13 wird die EUV-Strahlung 10 von einem Pupillenfacettenspiegel 14 mit einer Vielzahl von Pupillenfacetten 14a reflektiert. Der Pupillenfacettenspiegel 14 ist in einer Pupillenebene der Beleuchtungsoptik 4 angeordnet, die zu einer Pupillenebene der Projektionsoptik 7 optisch konjugiert ist. Mit Hilfe des Pupillenfacettenspiegels 14 und einer abbildenden optischen Baugruppe in Form einer Übertragungsoptik 15 mit in der Reihenfolge des Strahlengangs bezeichneten Spiegeln 16, 17 und 18 werden die Feldfacetten 13a des Feldfacettenspiegels 13 einander überlagernd in das Objektfeld 5 abgebildet. Der letzte Spiegel 18 der Übertragungsoptik 15 ist ein Spiegel mit streifendem Einfall (gracing incidence Spiegel; GI-Spiegel).

Fig. 2 zeigt stärker im Detail den Kollektor 11. Dieser hat, soweit die Strahlungsquelle 3 als LPP-Quelle ausgeführt ist, eine Durchtrittsöffnung 19 für Pumplicht zur Erzeugung des Plasmas. Dieses Pumplicht kann eine Pumplicht-Wellenlänge im infraroten Wellenlängenbereich, beispielsweise von 10,6 µm haben.

Der Kollektor 11 stellt ein Beispiel für ein optisches Element dar, welches nach einem Verfahren hergestellt wird, welches nachfolgend noch näher beschrieben ist.

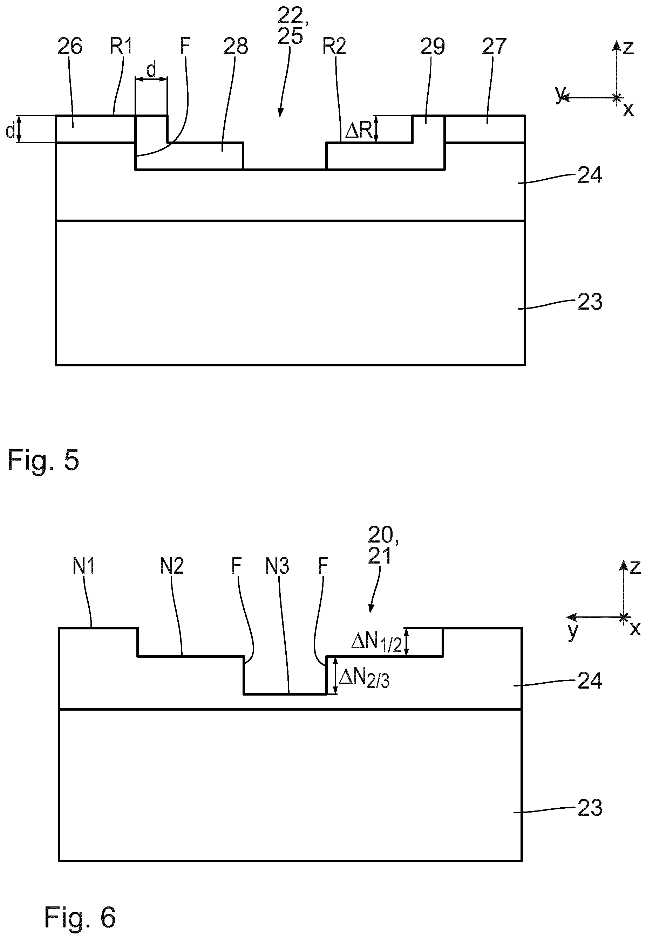

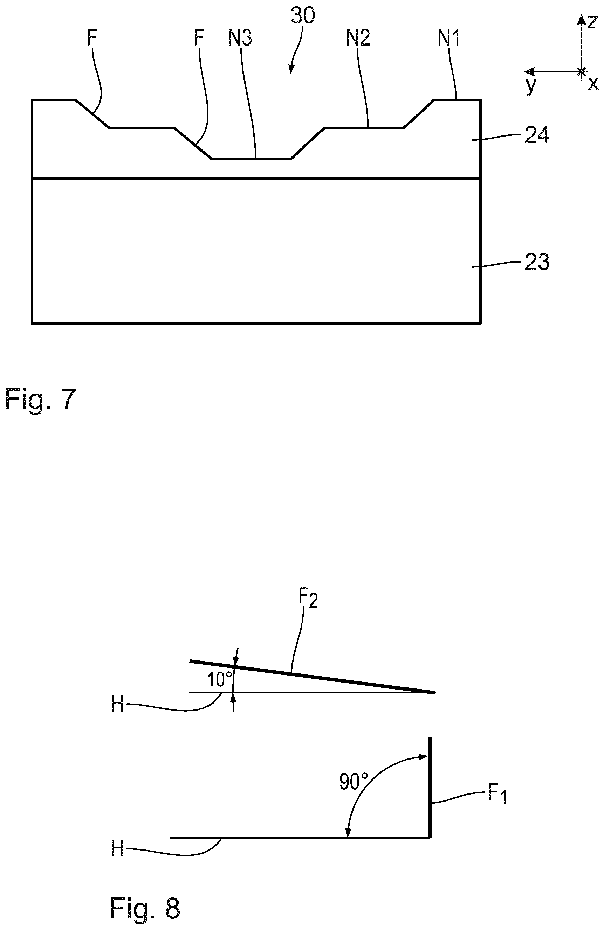

Der Kollektor 11 hat eine optische Fläche 20, die eine Beugungsstruktur 21 aufweist, von der als Ergebnis des Herstellungsverfahrens Beispiele in den Figuren 6 und 7 abschnittsweise dargestellt sind. Die Beugungsstruktur 21 dient zur Unterdrückung von Falschlicht-Wellenlängen, die sich von der Nutz-Beleuchtungslicht-Wellenlänge des Beleuchtungslichts 10 unterscheiden, für deren Kollektor-Reflexion der Kollektor 11 ausgelegt ist. Bei zu unterdrückenden Falschlicht-Wellenlängen handelt es sich zum einen um die IR-Wellenlänge des Pumplasers und zum anderen um vom erzeugten Plasma neben der Nutzlicht-Wellenlänge zusätzlich erzeugte EUV- und VUV-Wellenlängen im Bereich kleiner als eine Nutzlichtwellenlänge von beispielsweise 13 nm und in einem Bereich größer als diese Nutzlicht-Wellenlänge bis hin zu einem Bereich von beispielsweise 250 nm.

Die Beugungsstruktur 21 ist so ausgelegt, dass sie zwei sich voneinander unterscheidende Falschlicht-Wellenlängenbereiche unterdrückt, nämlich einerseits einen IR-Wellenlängenbereich und andererseits einen VUV-Wellenlängenbereich.

Die optische Fläche 20 des Kollektors 11 ist konkav gekrümmt. Eine gemittelte Flächennormale N der optischen Fläche 20 verläuft auf einer Rotations-Symmetrieachse der optischen Fläche 20. Die Flächennormale N verläuft parallel zur z-Achse des lokalen xyz-Koordinatensystems des Kollektors 11. Längs dieser gemittelten Flächennormale N gemessen liegt zwischen einem tiefsten Punkt T der optischen Fläche 20 und einem höchsten Punkt H auf einem Rand der optischen Fläche 20 ein Abstand A vor. Die optische Fläche 20 des Kollektors 11 ist gesehen aus der z-Richtung rund und hat einen Durchmesser D. Ein Abstands-Durchmesser-Verhältnis A/D ist ein Maß für eine Krümmung der optischen Fläche 20 des Kollektors 11. Dieses Verhältnis A/D ist beim Kollektor 11 etwa 1/4. Je nach Ausführung des optischen Elements mit den herzustellenden Beugungsstrukturen, für welches der Kollektor 11 ein Beispiel ist, ist das Verhältnis A/D im Bereich zwischen 1/10 und 1/1.

Der Durchmesser D der optischen Fläche 20 ist größer als 100 mm und beträgt beim dargestellten Ausführungsbeispiel etwa 150 mm. Je nach Ausführung des optischen Elements, für welches der Kollektor 11 ein Beispiel ist, kann ein größter Durchmesser der optischen Fläche 20 im Bereich zwischen 100 mm und 10 m liegen.

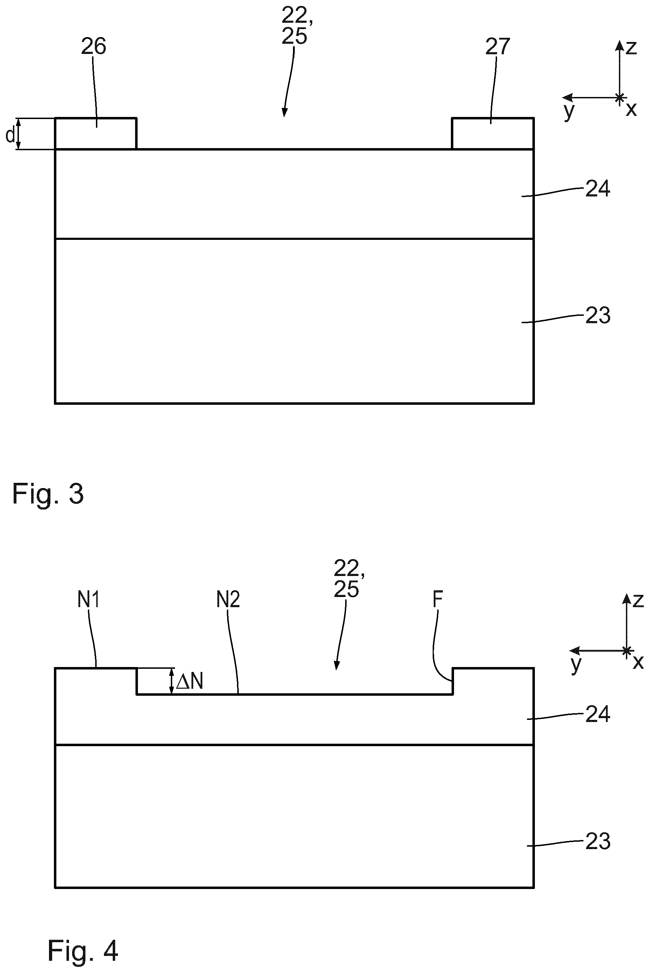

Anhand der Figuren 3 bis 6 wird nachfolgend ein Verfahren zur Herstellung des Kollektors 11 mit der die Beugungsstruktur 21 aufweisenden optischen Fläche 20 beschrieben. Fig. 3 zeigt eine Momentaufnahme des Herstellungsverfahrens. Gezeigt ist sehr stark vergrößert ein Abschnitt einer optischen Roh-Fläche 22, aus der im Zuge des Herstellungsverfahrens die optische Fläche 20 wird. Ein Grundkörper 23 der optischen Roh-Fläche 22 trägt eine strukturierbare Schicht 24, in der die Beugungsstruktur eingebracht wird.

Das optische Roh-Element 25 mit der optischen Roh-Fläche 22 hat ein Roh-Abstands-Durchmesser-Verhältnis, welches vom Abstands-Durchmesser-Verhältnis A/D des fertigen Kollektors 11 um nicht mehr als 10 % abweicht. Die optische Roh-Fläche 22 hat also eine Krümmung, die derjenigen des fertigen optischen Elements 11 entspricht.

In der Momentdarstellung, die in der Fig. 3 gezeigt ist, ist die strukturierbare Schicht 24 strukturiert mit Abschnitten 26, 27 eines Photoresists beschichtet. Diese Beschichtung ist mithilfe eines isotropen Abscheideverfahrens erfolgt. Als isotrope Abscheideverfahren zur Photoresist-Beschichtung des optischen Roh-Elements 25 stehen alternativ einerseits das Verfahren der elektrophoretischen Abscheidung und andererseits das Verfahren der Moleküllagenabscheidung zur Verfügung.

Bei der elektrophoretischen Abscheidung (EPD) werden kolloidale Partikel unter Einfluss eines elektrischen Feldes auf einer Elektrode, nämlich der optischen Roh-Fläche 22, abgeschieden. Das Abscheideverfahren ist konform, sodass die Photoresist-Abschnitte 26, 27 die Form der strukturierbaren Schicht 24 in den aufgetragenen Abschnitten exakt wiedergeben. Die Abschnitte 26, 27 des Photoresists sind mit einer Dicke d aufgetragen, die im Bereich zwischen 5 µm und 20 µm, beispielsweise bei 6 µm, 8 µm oder 10 µm, liegt. Eine Dickenvariation der Dicke d über die xy-Grundfläche der optischen Roh-Fläche 22 ist kleiner als 2 µm und ist insbesondere kleiner als 1 µm, kleiner als 0,5 µm und kann einen Wert von 0,4 µm erreichen. Beispielsweise schwankt die Dicke der aufgetragenen Photoresist-Abschnitte 26, 27 über die gesamte optische Roh-Fläche 22 des Kollektors 11 um nicht mehr als 0,4 µm und kann beispielsweise zwischen 7,8 µm und 8,2 µm liegen.

Als EPD-Photoresist kann eine wässrige Suspension zum Einsatz kommen, in der ein Feststoff als Mizellen bezeichnet ist. Diese Mizellen können aus einer Acryl-Co-Polymerhülle bestehen, die durch Oberflächenladungen von ionisierbaren Aminogruppen stabilisiert werden. Details zur elektrophoretischen Abscheidung findet der Fachmann in der US 3,738,835, der DE 19 258 094 A1 und der EP 0 176 356 B1.

Die Abscheidung der Photoresist-Abschnitte 26, 27 erfolgt in einer Abscheidezelle. An das leitfähige Werkstück, also das optische Roh-Element 25, wird ein Potential angelegt, dessen Polarität die geladenen Zellen des Photoresists anzieht, wobei diese auf der strukturierbaren Schicht 24 zu einem gleichmäßigen Film koagulieren. Die Schichtdicke d der Photoresist-Abschnitte 26, 27 und eine Verteilung der Abschnitte 26, 27 können von einer angelegten Abscheidespannung, einer Abscheide-Temperatur und einer Abscheide-Verweilzeit abhängen und hierüber entsprechend gesteuert werden.

Fig. 4 zeigt die Situation nach einem Entwickeln des Photoresists, also nach einem Ätzen und einem Entfernen der Photoresist-Abschnitte 26, 27. In der strukturierbaren Schicht 24 sind nun zwei Niveaus ausgebildet, nämlich ein höheres Niveau N1 dort, wo die Photoresist-Abschnitte 26, 27 vorlagen, und ein tieferes Niveau N2 dort, wo die strukturierbare Schicht frei lag, also nicht mit Photoresist beschichtet war. Eine Flankensteilheit von Strukturflanken F zwischen dem höheren Niveau N1 und dem tieferen Niveau N2 beträgt in guter Näherung 90°. Die Flanken F stehen also senkrecht auf den Oberflächen einerseits des höheren Niveaus N1 und andererseits des tieferen Niveaus N2.

Fig. 8 verdeutlicht die Definition des Parameters "Flankensteilheit in Grad". Dargestellt sind beispielhaft zwei Flanken F₁ und F₂ einer Beugungsstruktur. Die Flanke F₁ mit Flankensteilheit 90° schließt mit einer Horizontalen H (entsprechend xy-Ebene in den Figuren 3 bis 7) einen Winkel von 90° ein. Die Flanke F₂ mit Flankensteilheit 10° schließt mit der Horizontalen H einen Winkel im Bereich von 10° ein.

Fig. 5 zeigt die Situation nach einem weiteren, zweiten Beschichtungsschritt bei dem die strukturierbare Schicht 24 der optischen Roh-Fläche 22 ein weiteres Mal mit Abschnitten 28, 29 eines Photoresists beschichtet wurde. Aufgrund der Beschichtung mithilfe der elektrophoretischen Abscheidung folgen die Formen der Photoresist-Abschnitte 28, 29 exakt der bereits eingebrachten Struktur in der strukturierbaren Schicht 24. Entsprechend liegen bei den Photoresist-Abschnitten 26, 27 zwei Resist-Niveaus R1 (höheres Niveau) und R2 (tieferes Niveau) vor, deren Niveauunterschied ΔR exakt so groß ist wie der Niveauunterschied ΔN zwischen den Niveaus N1 und N2 der strukturierbaren Schicht 24 beim Herstellschritt nach Fig. 4.

Auch im Bereich der Flanken F der strukturierbaren Schicht 24 liegt nach dem Beschichtungsschritt nach Fig. 5 das Photoresist mit einer Dicke d, gemessen in der y-Richtung, vor. Die Flanken F der strukturierbaren Schicht 24 sind also dort, wo dies gewünscht ist, sicher mit dem Photoresist bedeckt.

Fig. 6 zeigt die hinsichtlich der herzustellenden Beugungsstruktur fertige optische Fläche 20 nach der Entwicklung der optischen Roh-Fläche 22 mit den Photoresist-Abschnitten 28, 29. Die Beugungsstruktur ist als ternäre Struktur mit drei Niveaus N1, N2 und N3 ausgeführt.

Das tiefste Niveau N3 ist dort, wo zwischen den Photoresist-Abschnitten 28, 29 ein Zwischenraum vorlag und die strukturierbare Schicht 24 somit für den Ätzprozess frei war. Auch die Flanken F zwischen den Niveaus N2 und N3 haben eine Flankensteilheit, die in guter Näherung 90° beträgt.

Mit ternären Strukturen entsprechend der Beugungsstruktur 20 kann je nach Gestaltung der Niveauunterschiede ΔN_{1/2}, ΔN_{2/3} und je nach der Erstreckung der Niveaus N1, N2 und N3 in der xy-Ebene die gewünschte Falschlichtunterdrückung erreicht werden.

Beim alternativen Verfahren der Moleküllagenabscheidung werden die Photoresist-Abschnitte 26, 27 einerseits und 28, 29 andererseits nicht, wie vorstehend erläutert, über die elektrophoretische Abscheidung, sondern über die Moleküllagenabscheidung abgeschieden. Ein derartiges Verfahren ist beschrieben beispielsweise in der US 2012/0121932 A1. Eine Abscheidung des Photoresists erfolgt durch zwei oder mehrere zyklisch durchgeführte selbstbegrenzende Oberflächenreaktionen. Dabei werden Molekülfragmente abgeschieden. Als Photoresiste können Photoresistsysteme eingesetzt werden, die molekulare Gläser bilden und aus mehreren Komponenten bestehen. Aus einer dieser Komponenten, einer Fotosäure (photoacid generator, PAG) wird durch Bestrahlung bei geeigneter Wellenlänge in mehreren Schritten eine Säure frei, die bei kurzer Erwärmung des Systems (post-exposure bake, PEB) katalytisch eine Reaktion zwischen den anderen Komponenten des Photoresistsystems auslöst. Dieser Prozess wird als chemische Verstärkung (chemical amplification) bezeichnet, da durch ein Bestrahlungs-Photon eine Vielzahl von Komponentenreaktionen initiiert wird.

Alternativ kann als Photoresist ein Photoresistsystem auf Basis von mit sich selbst reagierenden Cumarinderivaten zum Einsatz kommen, welche bei UV-Belichtung mit einer Wellenlänge größer als 300 nm einer [2+2]-Zykloaddition unterliegen. Dadurch können, je nach Anzahl funktioneller Gruppen, im Molekül des Photoresistsystems Molekül-Dimere, MolekülKetten oder auch Molekül-Netzwerke entstehen. Es kommen bevorzugt 1,3-Dibenzyl-5-tert-Butylcumarinester und 3,5-Di-tert-Butylbenzylcumarinester zum Einsatz, die transparente, amorphe Filme bilden. Nach einer Belichtung können die Monomere in unbelichteten Bereichen in einer Hochvakuumeinrichtung abgedampft werden, sodass im Ergebnis die Eigenschaften eines Photoresists, allerdings im Rahmen einer "trockenen" Photolithografie resultieren.

Nach dem Entfernen der Photoresist-Abschnitte kann die erzeugte Beugungsstruktur 21 mit einer Versiegelungsschicht beziehungsweise Schutzschicht versehen werden. Dies kann über eine Atomlagenabscheidung (ALD) erfolgen, was bekannt ist beispielsweise aus der US 9,640,291 B2 und der US 2016/0086681 A1. Als Schutzschicht kann insbesondere eine Molybdän-Silizium-Doppellagenstruktur dienen. Details eines derartigen Schichtstapels sind aus dem Stand der Technik bekannt.

Die Verfahrensschritte "Entwickeln des Photoresists" und "Entfernen von Photoresist-Rückständen" sind bekannt aus der US 6,352,747 B1.

Fig. 7 zeigt in einer ähnlichen Darstellung zu Fig. 6 eine weitere Ausführung einer Beugungsstruktur 30, die anstelle der Beugungsstruktur 21 oder der nachfolgend noch beschriebenen Beugungsstrukturen bei der Herstellung des optischen Elements, also insbesondere des Kollektors 11, erzeugt werden kann. Komponenten und Funktionen, die denjenigen entsprechen, die vorstehend unter Bezugnahme auf die Ausführung nach den Figuren 2 bis 6 und insbesondere nach den Figuren 3 bis 6 bereits erläutert wurden, tragen die gleichen Bezugsziffern und werden nicht nochmals im Einzelnen diskutiert.

Auch die Beugungsstruktur 30 hat drei Strukturniveaus N1, N2 und N3. Flanken F zwischen den Niveaus N1 und N2 einerseits und N2 und N3 andererseits haben eine Flankensteilheit, die im Bereich von 40° oder 45° liegt.

Beugungsstrukturen mit Flanken F mit einer Flankensteilheit insbesondere im Bereich zwischen 10° und 80° und beispielsweise im Bereich zwischen 30° und 60° können hergestellt werden mithilfe insbesondere der Graustufen-Lithografie. Informationen zu entsprechenden Herstellungstechniken für Flanken F mit derartigen Flankensteilheiten findet der Fachmann in den Fachartikeln von A. Grushina, Advanced Optics Techn. 2019; 8 (3 bis 4): 163-169, von T. Weichelt et al., Optics Express, Volume 25, Nr. 18, 20983 bis 20992, 2017, von T. Weichelt et al., Journal of Optics 18 (2016) 125401, von C. Stilson et al., Proceedings of SPIE 8973: Micromachining and Microfabrication Process Technology XIX, Nr. 8973 (März 2014), von K. Reimer et al., Proceeding SPIE Vol. 3008, p. 279 bis 288, 1997, von T.J. Suleski, Applied Optics, Volume 34, Nr. 32, 7507 bis 7517, 1995 und von D.C. O'Shea et al., Applied Optics, Volume 34, Nr. 32, 7518 bis 7526, 1995, und den dort angegebenen Referenzen.

Durch Vorgabe der Flankensteilheit lassen sich insbesondere geblazete Beugungsstrukturen herstellen.

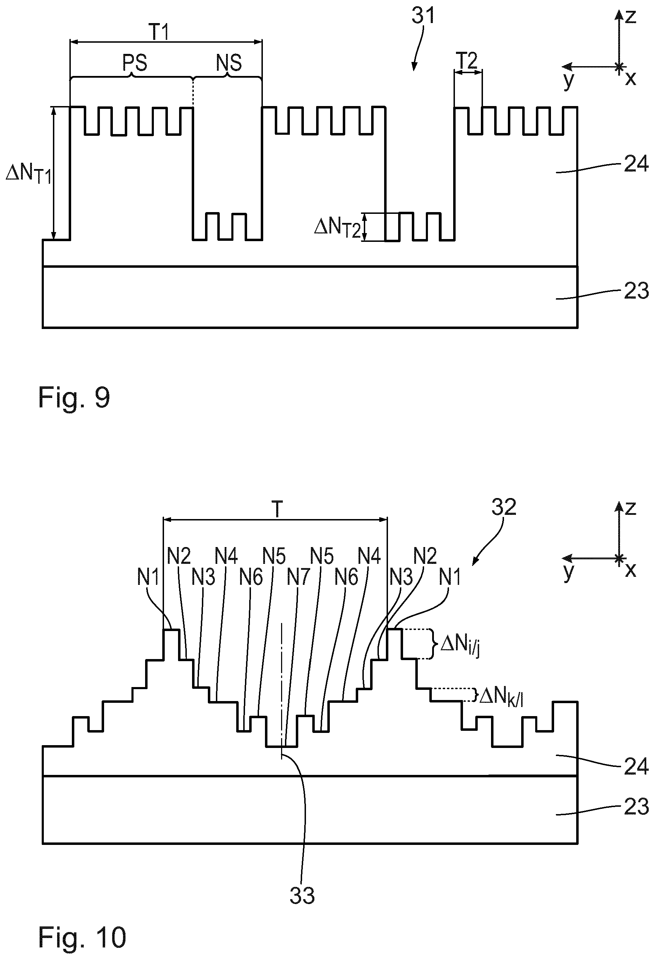

Anhand der Figuren 9 und 10 werden nachfolgend zwei weitere Ausführungen von Beugungsstrukturen 31, 32 beziehungsweise optischen Gittern beschrieben, die anstelle der vorstehend erläuterten Beugungsstrukturen bei der Herstellung des optischen Elements, also insbesondere des Kollektors 11, erzeugt werden können. Komponenten und Funktionen, die denjenigen entsprechen, die vorstehend unter Bezugnahme auf die Ausführung nach den Figuren 2 bis 8 und insbesondere nach den Figuren 6 und 7 bereits erläutert wurden, tragen die gleichen Bezugsziffern und werden nicht nochmals im Einzelnen diskutiert.

Die Beugungsstruktur 31 nach Fig. 9 ist als multiperiodisches Beugungsgitter mit Perioden T1 und T2 ausgeführt. Es gilt: T1 = 7T2, wobei das Verhältnis T1/T2 beispielsweise im Bereich zwischen 1,1:1 und 100:1 liegen kann und auch noch außerhalb dieses Bereichs liegen kann. Innerhalb der Periode T1 liegt die Periode T2 also insgesamt siebenmal vor, wobei eine Positivstruktur PS der Periode T1 sich über insgesamt 4,5 Gitterperioden T2 erstreckt und eine Negativstruktur NS der Gitterperiode T1 sich über die restlichen 2,5 Gitterperioden T2. Ein Duty Cycle des Gitters mit der Periode T1 beträgt also 9/5. Ein Niveauunterschied ΔN_{T1} des Gitters mit der Periode T1 ist etwa fünfmal so groß wie ein Niveauunterschied ΔN_{T2} des Gitters mit der Periode T2.

Ein Duty Cycle des Gitters mit der Periode T2 beträgt 1:1. Dort hat die jeweilige Positivstruktur also in der längs der y-Richtung verlaufenden Gitter-Laufrichtung die gleiche Erstreckung wie eine der Negativstrukturen des Gitters mit der Periode T2.

Über die Gitterperioden T1, T2, über die Niveauunterschiede ΔN_{T1}, ΔN_{T2} sowie über die Duty Cycles der beiden Gitter der Gitterperioden T1, T2 lässt sich eine Falschlicht-Unterdrückungscharakteristik der Beugungsstruktur 31 fein vorgeben.

Die Beugungsstruktur 32 nach Fig. 10 ist als mehrfachstufiges Beugungsgitter mit einer Gitterperiode T ausgeführt. Insgesamt hat die Beugungsstruktur 32 innerhalb einer Periode sieben verschiedene Beugungsniveaus N1 bis N7, wobei eine Strukturhöhe eines Niveaus Ni+1 jeweils niedriger ist als diejenige des Niveaus Ni. Die Abfolge dieser Strukturniveaus innerhalb der Periode T ist N1, N2, N3, N4, N6, N5, N7, N5, N6, N4, N3 und N2. Auch andere Anzahlen von Strukturniveaus sowie andere Abfolgen sind je nach Ausführung des multiperiodischen Gitters der Beugungsstruktur 32 möglich.

Zudem hat die Beugungsstruktur 32 zwei verschiedene Niveauunterschiede ΔN_{i/j} sowie ΔN_{k/l}. Der größere Niveauunterschied ΔN_{i/j}, der im Ausführungsbeispiel der Fig. 10 zwischen den Niveaus N1/N2, N2/N3, N4/N6 und N5/N7 vorliegt, ist etwa doppelt so groß wie der Niveauunterschied ΔN_{k/l}, der zwischen den Niveaus N3/N4, N6/N5 vorliegt.

Um das tiefste Niveau N7 ist die Niveauanordnung der Beugungsstruktur 32 um eine zur xz-Ebene parallele Ebene 33 spiegelsymmetrisch.

Über die relativen Strukturhöhen der Niveaus N1 bis N7, die Strukturhöhen-Abfolge der Niveaus N1 bis N7 sowie über die Niveauunterschiede ΔN_{i/j} und ΔN_{k/l} lassen sich Falschlicht-Unterdrückungsparameter der Beugungsstruktur 32 fein vorgeben.

Auch andere Anzahlen absoluter Niveauunterschiede sowie eine andere Anzahl verschiedener Niveauunterschiede sind je nach Ausführung der Beugungsstruktur 32 möglich.

Mit Hilfe der Projektionsbelichtungsanlage 1 wird wenigstens ein Teil des Retikels im Objektfeld 5 auf einen Bereich einer lichtempfindlichen Schicht auf dem Wafer im Bildfeld 8 zur lithographischen Herstellung eines mikro- bzw. nanostrukturierten Bauteils, insbesondere eines Halbleiterbauteils, beispielsweise eines Mikrochips, abgebildet. Hierbei wird der Photoresist strukturiert belichtet und im Anschluss hieran entwickelt. Je nach Ausführung der Projektionsbelichtungsanlage 1 als Scanner oder als Stepper werden das Retikel und der Wafer zeitlich synchronisiert in der y-Richtung kontinuierlich im Scannerbetrieb oder schrittweise im Stepperbetrieb verfahren.

## Patentansprüche

1. Verfahren zum Herstellen eines optischen Elements (11) mit einer optischen Fläche (20), die eine Beugungsstruktur (21; 30; 31; 32) aufweist,
- wobei die optische Fläche (20) derart gekrümmt ist, dass ein Abstands-Durchmesser-Verhältnis A/D zwischen
-- einem Abstand A, gemessen längs einer gemittelten Flächennormalen (N) der optischen Fläche (20), zwischen einem tiefsten Punkt (T) und einem höchsten Punkt (H) auf der optischen Fläche (20), wobei die Richtung der gemittelten Flächennormalen bei einer rotationssymmetrischen optischen Fläche mit zur Rotationssymmetrieachse rotationssymmetrischer Berandungsfläche der Richtung der Rotationssymmetrieachse entspricht, und
-- einem größten Durchmesser D der optischen Fläche (20) größer ist als 1/10,
mit folgenden Schritten:
- Bereitstellen eines optischen Roh-Elements (25) mit einer mit der Beugungsstruktur (21; 30; 31; 32) zu versehenden optischen Roh-Fläche (22),
- Beschichten der optischen Roh-Fläche (22) mit einem Photoresist (26, 27; 28, 29),
- strukturiertes Belichten des Photoresists,
- Entwickeln des Photoresists (26, 27; 28, 29),
- wobei die Beugungsstruktur (21; 30; 31; 32) derart ausgeführt ist,
-- dass beim Beaufschlagen des optischen Elements (11) mit Beleuchtungslicht (10) mindestens eine Falschlicht-Wellenlänge durch Beugung unterdrückt wird, die sich von einer Beleuchtungslicht-Wellenlänge des Beleuchtungslichts (10) unterscheidet, für welches das optische Element (11) ausgelegt ist, und
-- dass beim Beaufschlagen des optischen Elements (11; 30; 31; 32) mit Beleuchtungslicht (10) zwei sich voneinander unterscheidende Falschlicht-Wellenlängenbereiche unterdrückt werden,
**dadurch gekennzeichnet, dass**
- das Beschichten mithilfe eines isotropen Abscheideverfahrens erfolgt, wobei Strukturflanken der optischen Beugungsstruktur isotrop mit gewünschter Schichtdicke mit dem Photoresist beschichtet werden, sodass eine konforme, homogene Beschichtung der optischen Roh-Fläche mit dem Photoresist gewährleistet ist,
- wobei es sich bei den beiden Falschlicht-Wellenlängenbereichen einerseits um einen Falschlicht-Wellenlängenbereich um eine Laser-Pumplicht-Wellenlänge und andererseits um einen weiteren Falschlicht-Wellenlängenbereich um eine Nutzlicht-Wellenlänge des Beleuchtungslichts unter Aussparung genau dieser Nutzlicht-Wellenlänge handelt,
- wobei der eine der beiden zu unterdrückenden Falschlicht-Wellenlängenbereiche ein IR-Wellenlängenbereich ist,
- wobei der andere der beiden zu unterdrückenden Falschlicht-Wellenlängenbereiche ein VUV-Wellenlängenbereich zwischen 100 nm und 200 nm ist.

2. Verfahren nach Anspruch 1, **dadurch gekennzeichnet, dass** beim Beschichten der Photoresist (26, 27; 28, 29) mit einer Dicke D aufgetragen wird, die im Bereich zwischen 5 µm und 20 µm liegt.

3. Verfahren nach Anspruch 1 oder 2, **gekennzeichnet durch** eine Dickenvariation des aufgetragenen Photoresists (26, 27; 28, 29), die kleiner ist als 20% einer maximalen Dicke des aufgetragenen Photoresists (26, 27, 28, 29).

4. Verfahren nach einem der Ansprüche 1 bis 3, **dadurch gekennzeichnet, dass** das Beschichten mittels einer elektrophoretischen Abscheidung erfolgt.

5. Verfahren nach einem der Ansprüche 1 bis 3, **dadurch gekennzeichnet, dass** das Beschichten mittels einer Moleküllagenabscheidung erfolgt.

6. Optisches Element (11), hergestellt mit einem Verfahren nach einem der Ansprüche 1 bis 5.

7. Optisches Element nach Anspruch 6, ausgeführt als EUV-Kollektor zum Einsatz in einer Projektionsbelichtungsanlage.

8. Optisches Element nach Anspruch 6 oder 7, **dadurch gekennzeichnet, dass** der Durchmesser der optischen Fläche (20) größer ist als 100 mm.

9. Optisches Element nach einem der Ansprüche 6 bis 8, **dadurch gekennzeichnet, dass** die Beugungsstruktur (21; 30; 31; 32) eine Flankensteilheit hat, die größer ist als 10°.

10. Optisches Element nach einem der Ansprüche 6 bis 9, dadurch gekennzeichet, dass innerhalb des jeweiligen Falschlicht-Wellenlängenbereichs mehrere diskrete Falschlicht-Wellenlängen unterdrückt werden.

11. Beleuchtungssystem (2) mit einem optischen Element nach einem der Ansprüche 6 bis 10 und mit einer EUV-Strahlungsquelle (3).

12. Projektionsbelichtungsanlage für die EUV-Projektionslithografie mit einem Beleuchtungssystem nach Anspruch 11 und mit einer Beleuchtungsoptik (4) zur Überführung des Beleuchtungslichts (10) von Strahlungsquelle (3) in ein Objektfeld (5), in dem ein Retikel mit abzubildenden Strukturen anordenbar ist, und mit einer Projektionsoptik (7) zur Abbildung des Objektfeldes (5) in ein Bildfeld (8).

13. Verfahren zur Herstellung eines mikro- oder nanostrukturierten Bauelements mit folgenden Schritten:
- Bereitstellen eines Substrats (9a), auf welches zumindest teilweise eine Schicht aus einem lichtempfindlichen Material aufgebracht ist,
- Bereitstellen eines Retikels (6a), welches abzubildende Strukturen aufweist,
- Projizieren mindestens eines Teils des Retikels (6a) auf einen Bereich der lichtempfindlichen Schicht des Substrats (9a) mithilfe der Projektionsbelichtungsanlage nach Anspruch 12**.**

## Claims

1. Method for producing an optical element (11) with an optical surface (20) having a diffraction structure (21; 30; 31; 32),
- wherein the optical surface (20) is curved such that a distance-to-diameter ratio A/D between
-- a distance A, measured along an averaged surface normal (N) of the optical surface (20), between a deepest point (T) and a highest point (H) on the optical surface (20), wherein the direction of the averaged surface normal in the case of a rotationally symmetrical optical surface having a boundary surface that is rotationally symmetrical with respect to the axis of rotational symmetry corresponds to the direction of the axis of rotational symmetry, and
-- a largest diameter D of the optical surface (20) is greater than 1/10,
comprising the following steps:
- providing a raw optical element (25) having a raw optical surface (22) to be provided with the diffraction structure (21; 30; 31; 32),
- coating the raw optical surface (22) with a photoresist (26, 27; 28, 29),
- structured exposure of the photoresist,
- development of the photoresist (26, 27; 28, 29),
- wherein the diffraction structure (21; 30; 31; 32) is embodied such
-- that when illumination light (10) impinges on the optical element (11), at least one extraneous light wavelength which differs from an illumination light wavelength of the illumination light (10) for which the optical element (11) is designed is suppressed by diffraction, and
-- that when illumination light (10) impinges on the optical element (11; 30; 31; 32), two mutually different extraneous light wavelength ranges are suppressed,
**characterized in that**
- the coating is effected with the aid of an isotropic deposition method, wherein structure sidewalls of the optical diffraction structure are coated with the photoresist isotropically with a desired layer thickness, such that a conformal, homogeneous coating of the raw optical surface with the photoresist is ensured,
- wherein the two extraneous light wavelength ranges are, firstly, an extraneous light wavelength range around a laser pump light wavelength and, secondly, a further extraneous light wavelength range around a used light wavelength of the illumination light, omitting exactly this used light wavelength,
- wherein one of the two extraneous light wavelength ranges to be suppressed is an IR wavelength range,
- wherein the other of the two extraneous light wavelength ranges to be suppressed is a VUV wavelength range of between 100 nm and 200 nm.

2. Method according to Claim 1, **characterized in that**, during coating, the photoresist (26, 27; 28, 29) is applied with a thickness D which is in the range of between 5 µm and 20 µm.

3. Method according to Claim 1 or 2, **characterized by** a thickness variation of the applied photoresist (26, 27; 28, 29) which is less than 20% of a maximum thickness of the applied photoresist (26, 27, 28, 29).

4. Method according to any of Claims 1 to 3, **characterized in that** the coating is effected by means of an electrophoretic deposition.

5. Method according to any of Claims 1 to 3, **characterized in that** the coating is effected by means of a molecular layer deposition.

6. Optical element (11), produced by a method according to any of Claims 1 to 5.

7. Optical element according to Claim 6, embodied as an EUV collector for use in a projection exposure apparatus.

8. Optical element according to Claim 6 or 7, **characterized in that** the diameter of the optical surface (20) is greater than 100 mm.

9. Optical element according to any of Claims 6 to 8, **characterized in that** the diffraction structure (21; 30; 31; 32) has a sidewall steepness which is greater than 10°.

10. Optical element according to any of Claims 6 to 9, **characterized in that** a plurality of discrete extraneous light wavelengths are suppressed within the respective extraneous light wavelength range.

11. Illumination system (2) comprising an optical element according to any of Claims 6 to 10 and comprising an EUV radiation source (3).

12. Projection exposure apparatus for EUV projection lithography comprising an illumination system according to Claim 11 and comprising an illumination optical unit (4) for transferring the illumination light (10) from radiation source (3) into an object field (5), in which a reticle with structures to be imaged is arrangeable, and comprising a projection optical unit (7) for imaging the object field (5) into an image field (8).

13. Method for producing a micro- or nanostructured component, comprising the following steps:
- providing a substrate (9a), to which a layer composed of a light-sensitive material is at least partly applied,
- providing a reticle (6a) having structures to be imaged,
- projecting at least one part of the reticle (6a) onto a region of the light-sensitive layer of the substrate (9a) with the aid of the projection exposure apparatus according to Claim 12.

## Revendications

1. Procédé de production d'un élément optique (11) comprenant une surface optique (20) présentant une structure de diffraction (21 ; 30 ; 31 ; 32),
- dans lequel la surface optique (20) est incurvée de telle sorte qu'un rapport distance-diamètre A/d entre
-- une distance A, mesurée le long d'une normale de surface moyenne (N) de la surface optique (20), entre un point le plus bas (T) et un point le plus haut (H) sur la surface optique (20), la direction de la normale de surface moyenne correspondant à la direction de l'axe de symétrie de rotation dans le cas d'une surface optique à symétrie de rotation avec une surface de bordure à symétrie de rotation par rapport à l'axe de symétrie de rotation, et
-- un diamètre d maximum de la surface optique (20), est supérieur à 1/10,
comprenant les étapes suivantes :
- fourniture d'un élément optique brut (25) avec une surface optique brute (22) à doter de la structure de diffraction (21 ; 30 ; 31 ; 32),
- revêtement de la surface optique brute (22) par une résine photosensible (26, 27 ; 28, 29),
- exposition structurée de la résine photosensible,
- développement de la résine photosensible (26, 27 ; 28, 29),
- dans lequel la structure de diffraction (21 ; 30 ; 31 ; 32) est conçue de telle sorte
-- que lorsque l'élément optique (11) est exposé à de la lumière d'éclairage (10), au moins une longueur d'onde de fausse lumière est supprimée par diffraction, laquelle diffère d'une longueur d'onde de la lumière d'éclairage (10) pour laquelle l'élément optique (11) est conçu, et
-- que lorsque l'élément optique (11 ; 30 ; 31 ; 32) est exposé à de la lumière d'éclairage (10), deux plages de longueurs d'onde de fausse lumière différentes l'une de l'autre sont supprimées,
**caractérisé en ce que**
- le revêtement s'effectue à l'aide d'un procédé de dépôt isotrope, dans lequel des flancs de structure de la structure de diffraction optique sont revêtus de manière isotrope de la résine photosensible sur l'épaisseur de couche souhaitée, de sorte qu'un revêtement homogène et conforme de la surface optique brute avec la résine photosensible est assuré,
- les deux plages de longueurs d'onde de fausse lumière étant, d'une part, une plage de longueurs d'onde de fausse lumière située autour d'une longueur d'onde de lumière de pompe laser et, d'autre part, une autre plage de longueurs d'onde de fausse lumière située autour d'une longueur d'onde de lumière utile de la lumière d'éclairage, à l'exclusion exacte de cette longueur d'onde de lumière utile,
- l'une des deux plages de longueurs d'onde de fausse lumière à supprimer étant une plage de longueurs d'onde IR,
- l'autre des deux plages de longueurs d'onde de fausse lumière à supprimer étant une plage de longueurs d'onde VUV comprise entre 100 nm et 200 nm.

2. Procédé selon la revendication 1, **caractérisé en ce que**, pendant le revêtement, la résine photosensible (26, 27 ; 28, 29) est appliquée sur une épaisseur d qui se situe dans la plage comprise entre 5 µm et 20 µm.

3. Procédé selon la revendication 1 ou 2, **caractérisé par** une variation d'épaisseur de la résine photosensible appliquée (26, 27 ; 28, 29) qui est inférieure à 20 % d'une épaisseur maximale de la résine photosensible appliquée (26, 27, 28, 29).

4. Procédé selon l'une quelconque des revendications 1 à 3, **caractérisé en ce que** le revêtement est réalisé au moyen d'un dépôt électrophorétique.

5. Procédé selon l'une quelconque des revendications 1 à 3, **caractérisé en ce que** le revêtement est réalisé au moyen d'un dépôt de couches moléculaires.

6. Élément optique (11), produit par un procédé selon l'une quelconque des revendications 1 à 5.

7. Élément optique selon la revendication 6, conçu sous la forme d'un collecteur EUV destiné à être utilisé dans une installation d'exposition par projection.

8. Élément optique selon la revendication 6 ou 7, **caractérisé en ce que** le diamètre de la surface optique (20) est supérieur à 100 mm.

9. Élément optique selon l'une quelconque des revendications 6 à 8, **caractérisé en ce que** la structure de diffraction (21 ; 30 ; 31 ; 32) présente une raideur de flanc supérieure à 10°.

10. Élément optique selon l'une quelconque des revendications 6 à 9, **caractérisé en ce que** plusieurs longueurs d'onde discrètes de fausse lumière sont supprimées à l'intérieur de la plage de longueurs d'onde de fausse lumière respective.

11. Système d'éclairage (2) comprenant un élément optique selon l'une quelconque des revendications 6 à 10 et comprenant une source de rayonnement EUV (3).

12. Installation d'exposition par projection pour la lithographie par projection EUV comprenant un système d'éclairage selon la revendication 11 et comprenant une optique d'éclairage (4) pour guider la lumière d'éclairage (10) depuis la source de rayonnement (3) vers un champ objet (5) dans lequel peut être disposé un réticule doté de structures dont l'image doit être formée, et comprenant une optique de projection (7) destinée à former l'image du champ objet (5) dans un champ image (8).

13. Procédé de production d'un composant micro- ou nano-structuré comprenant les étapes suivantes :
- fourniture d'un substrat (9a) sur lequel est appliquée au moins partiellement une couche constituée d'un matériau photosensible,
- fourniture d'un réticule (6a) qui présente des structures dont l'image doit être formée,
- projection d'au moins une partie du réticule (6a) sur une zone de la couche photosensible du substrat (9a) au moyen de l'installation d'exposition par projection selon la revendication 12.
